# DEMANDE DE BREVET EUROPEEN

(11) **EP 1 179 739 A1**
(43) Date de publication de la demande: **13.02.2002**
(21) Numéro de dépôt: 01202908.8
(22) Date de dépôt: 31.07.2001
(51) Int. Cl.: G01R 31/3185

(54) **Procédé pour tester un circuit intégré à contrôle de cadencement flexible**

(30) Priorité: 08.08.2000 FR 0010441
(71) Demandeur: Koninklijke Philips Electronics N.V., 5621 BA Eindhoven (NL)
(72) Inventeur: Giaume, Olivier, 75008 Paris (FR); Faucon, Christelle, 75008 Paris (FR); Brochier, Béatrice, 75008 Paris (FR); Alves, Philippe, 75008 Paris (FR); Ponte, Christian, 75008 Paris (FR)
(74) Mandataire: Chaffraix, Jean

(57) **Abrégé**

La présente invention concerne un procédé pour tester un circuit intégré incluant des cellules mémoire disposées autour d'un coeur dont l'entrée d'horloge est soumise à une inhibition conditionnelle en mode test.

Le procédé selon l'invention inclut les étapes suivantes :
. configuration du circuit en mode test (T/R=1, TM, En=0),
. sélection d'une adresse virtuelle (Sel(DV)),
. levée de l'inhibition (En=1) de l'entrée d'horloge du coeur consécutive à ladite sélection.

L'invention permet d'acheminer au coeur suffisamment d'impulsions d'horloge pour qu'il puisse mener à bien la séquence opératoire qu'il doit émuler, sans recourir à une mémorisation préalable du nombre d'impulsions requis pour ladite séquence.

Le contrôle de l'inhibition de l'entrée d'horloge du coeur peut être réalisée au moyen de chaînes d'instructions conformes au standard JTAG.

## Description

La présente invention concerne un procédé pour tester un circuit intégré incluant un coeur et une pluralité de cellules mémoire présentant des sorties et des entrées alternativement connectées à des entrées et à des sorties du coeur, le coeur étant muni d'une entrée d'horloge destinée à recevoir un premier signal d'horloge en mode de fonctionnement normal, chaque cellule mémoire étant identifiée par une adresse et munie d'une entrée d'horloge destinée à recevoir un deuxième signal d'horloge en mode test, l'entrée d'horloge du coeur étant soumise à une inhibition conditionnelle en mode test.

Un tel procédé est décrit dans le brevet US 5,812,562. Selon le procédé connu, les cellules mémoire dont les sorties sont connectées à des entrées du coeur forment un premier registre de test, dit de contrôle, tandis que les cellules mémoire dont les entrées sont connectées à des sorties du coeur forment un deuxième registre de test, dit d'observation. L'accès en écriture ou en lecture depuis l'extérieur du circuit intégré à un bit de rang i de l'un ou l'autre de ces registres se fera par exemple au moyen de (i+1) décalages vers la droite du contenu du registre. L'adresse de la ième cellule mémoire incluse dans le registre sera donc sélectionnée, ladite adresse servant pour déterminer le nombre de décalages que devra subir le registre.
Lorsque le circuit intégré est en mode test, l'entrée d'horloge du coeur est à priori inhibée et le coeur est au repos.
Le test d'une séquence opératoire donnée se déroule généralement en trois temps :
Dans une première phase, dite de chargement, le registre de contrôle reçoit depuis l'extérieur des informations représentant des stimuli à appliquer au coeur pour en émuler une séquence opératoire déterminée. Ces stimuli simulent ainsi l'environnement auquel serait soumis le coeur s'il recevait l'ordre d'exécuter ladite séquence en mode de fonctionnement normal. Un tel chargement du registre de contrôle est cadencé au moyen du deuxième signal d'horloge.
Dans une deuxième phase, dite d'émulation, le coeur doit être remis en fonctionnement au moyen d'un signal d'horloge afin qu'il soit possible d'observer ses réponses aux stimuli contenus dans le registre de contrôle. Selon le procédé connu, un tel signal d'horloge est constitué par une succession d'impulsions dont le nombre est prédéterminé et stocké dans un registre d'horloge adjoint au registre de contrôle, les deux registres étant programmés simultanément au cours de la phase de chargement propre au test de chaque séquence opératoire, le nombre d'impulsions nécessaire au coeur pour compléter chaque séquence étant spécifique à ladite séquence.
L'inhibition de l'entrée d'horloge du coeur est alors levée et le coeur reçoit le nombre d'impulsions d'horloge requis pour mener à terme la séquence opératoire choisie.
A l'issue de cette phase d'émulation, le registre d'observation mémorise les signaux présents aux sorties du coeur.
Dans une troisième phase, dite de validation, la valeur du contenu du registre d'observation est comparée avec une valeur numérique de référence, représentative de la réponse que le coeur devait apporter aux stimuli qu'il a reçus. En cas d'identité entre ces valeurs, il sera conclu que le coeur a correctement exécuté la séquence opératoire choisie.

Le nombre d'impulsions d'horloge nécessaires à l'émulation d'une séquence opératoire varie d'une séquence à l'autre. Ainsi, il faudra attribuer au registre d'horloge une taille importante pour l'adapter à de longues séquences opératoires, qui nécessiteront un grand nombre d'impulsions d'horloge.
Dans le procédé connu, la taille du registre d'horloge est de l'ordre de 50% de celle du registre de contrôle. Ces registres étant chargés bit par bit selon un mode série, l'utilisation d'un registre d'horloge pour générer des impulsions d'horloge en mode test augmente la durée de la phase de chargement de 50%, et celle de la totalité du test d'une séquence opératoire de 30 à 50%, selon la durée de la phase d'émulation et la taille du registre d'observation. Une telle augmentation de la durée du test selon le procédé connu diminue le débit de production et augmente de manière significative le coût total de production du circuit intégré.

De plus, les dimensions du registre d'horloge étant définitivement fixées lors de la conception du circuit intégré, il faudra utiliser une surface de silicium importante pour réaliser la fonction de mémorisation du nombre d'impulsions d'horloge en mode test.
Par ailleurs, un dispositif de comptage/décomptage doit être utilisé afin de contrôler le nombre d'impulsions d'horloge envoyées au coeur, ce qui augmente encore la surface du circuit intégré mettant en oeuvre le procédé connu.

L'invention a pour but de remédier à ces inconvénients en proposant un procédé pour tester un circuit intégré selon lequel l'acheminement d'impulsions d'horloge au coeur en mode test est réalisé de manière simple et flexible, sans nécessiter de programmation, au sein d'un registre spécifique, d'un nombre d'impulsions propre à chaque séquence opératoire.

En effet, selon l'invention, un procédé conforme au paragraphe introductif inclut les étapes suivantes :
. configuration du circuit en mode test,
. sélection d'une adresse dite virtuelle ne correspondant à aucune cellule mémoire,
. levée de l'inhibition de l'entrée d'horloge du coeur pendant une durée prédéterminée consécutive à ladite sélection.

Selon ce procédé, la simple sélection d'une adresse virtuelle donne lieu à la transmission d'une impulsion d'horloge à l'entrée d'horloge du coeur. N sélections successives d'une adresse virtuelle permettront d'envoyer un train de N impulsions d'horloge au coeur. Il n'est donc plus nécessaire de pré-programmer ce nombre N dans un registre, ce qui confère au procédé conforme à l'invention une grande souplesse d'utilisation, qui se traduit par des économies en termes de surface de silicium et de coût de production du circuit intégré.

Dans un mode de mise en oeuvre particulier de l'invention, l'entrée d'horloge du coeur reçoit le deuxième signal d'horloge lorsque l'inhibition de ladite entrée d'horloge est levée pendant le mode test.

Un tel mode de mise en oeuvre permet de cadencer le circuit intégré au moyen du seul deuxième signal d'horloge pendant toute la durée du mode test, ce qui évite des commutations d'horloge qui s'avèrent toujours délicates à gérer.

Dans une variante de l'invention, la levée de l'inhibition de l'entrée d'horloge du coeur est en outre assujettie à l'exécution d'une opération relative à l'adresse virtuelle.

Selon cette variante de l'invention, la sélection d'une adresse virtuelle annonce la levée de l'inhibition de l'entrée d'horloge, la durée de cette levée d'inhibition, et donc le nombre d'impulsions d'horloge transmises au coeur, étant déterminées par le nombre d'opérations relatives à ladite adresse virtuelle qui seront exécutées.

Dans un mode de mise en oeuvre avantageux de cette variante, la levée de l'inhibition de l'entrée d'horloge du coeur est en outre assujettie à l'exécution d'une opération spécifique prédéterminée relative à l'adresse virtuelle.

Selon ce mode de mise en oeuvre, il n'est pas nécessaire de détecter toute opération relative à une adresse virtuelle, mais uniquement une opération spécifique, ce qui simplifie l'implémentation physique de cette étape, et réduit donc son coût.

Dans un mode de mise en oeuvre préféré de cette variante, l'opération spécifique prédéterminée est une opération de décalage.

Le fait de choisir une opération de décalage comme condition de levée d'inhibition permet d'utiliser une chaîne d'instructions conforme au standard JTAG pour commander l'acheminement d'une impulsion d'horloge au coeur en mode test.

Dans un de ses modes de réalisation, l'invention concerne également un circuit intégré incluant :
. un coeur muni d'une entrée d'horloge destinée à recevoir un premier signal d'horloge en mode de fonctionnement normal,
. une pluralité de cellules mémoire présentant des sorties et des entrées alternativement connectées à des entrées et à des sorties du coeur, chaque cellule mémoire étant identifiée par une adresse et munie d'une entrée d'horloge destinée à recevoir un deuxième signal d'horloge en mode test,
. un module de contrôle destiné à réaliser une inhibition de l'entrée d'horloge du coeur en mode test, agencés de manière à ce que ladite inhibition soit levée pendant une durée prédéterminée, après qu'une adresse virtuelle ne correspondant à aucune cellule mémoire ait été sélectionnée.

Dans une variante de ce mode de réalisation, le module de contrôle est configuré pour acheminer le deuxième signal d'horloge vers l'entrée d'horloge du coeur lorsque l'inhibition de ladite entrée est levée pendant le mode test.

Dans une autre variante de ce mode de réalisation, la levée de l'inhibition de l'entrée d'horloge du coeur pendant le mode test est en outre assujettie à l'exécution d'une opération relative à l'adresse virtuelle.

L'invention sera mieux comprise à l'aide de la description suivante d'un de ses modes de réalisation, faite à titre d'exemple non-limitatif et en regard des dessins annexés, dans lesquels :
- la figure 1 est un schéma fonctionnel décrivant un circuit intégré conforme à un mode de réalisation de l'invention,
- les figures 2A et 2B sont des organigrammes représentant le déroulement de séquences d'inhibition/levée d'inhibition incluses dans des procédés conformes à l'invention et à l'une de ses variantes, respectivement,
- la figure 3 est schéma fonctionnel représentant un module d'inhibition conditionnelle de l'entrée d'horloge du coeur, et
- la figure 4 est un ensemble de chronogrammes représentant l'évolution de signaux présents dans un tel module.

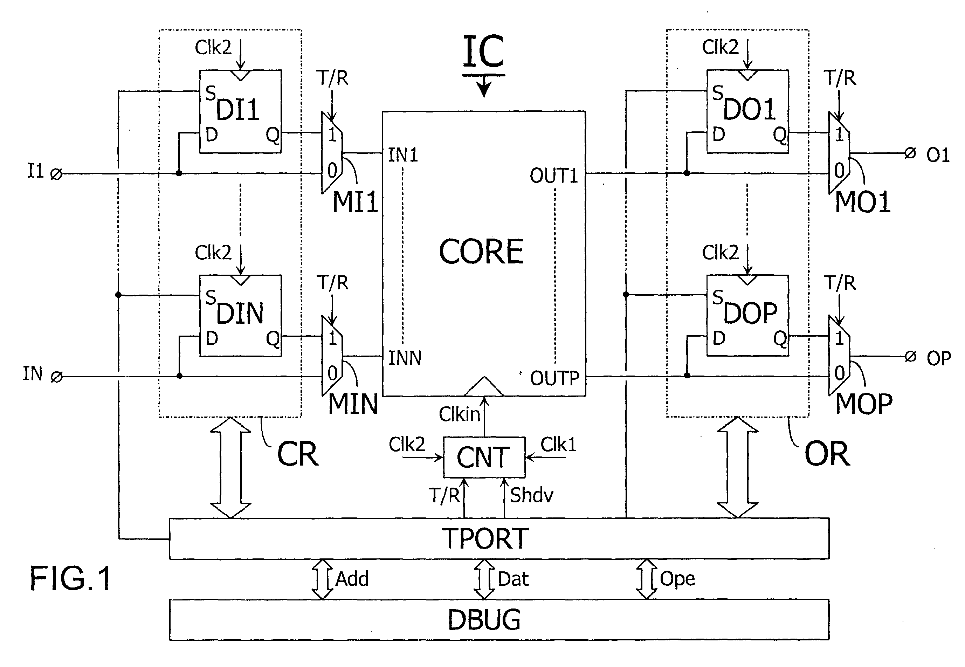

La figure 1 représente schématiquement un circuit intégré IC dans lequel l'invention est mise en oeuvre. Ce circuit intégré IC inclut :
. un coeur CORE muni d'une entrée d'horloge destinée à recevoir un premier signal d'horloge Clk1 en mode de fonctionnement normal,
. une pluralité de cellules mémoire DIi (pour i=1 à N) et DOj (pour j=1 à P) présentant des sorties Q et des entrées D alternativement connectées à des entrées INi (pour i=1 à N) et à des sorties OUTj (pour j=1 à P) du coeur CORE via des multiplexeurs MIi (pour i=1 à N) et MOj (pour j=1 à P), chaque cellule mémoire étant identifiée par une adresse et munie d'une entrée d'horloge destinée à recevoir un deuxième signal d'horloge Clk2 en mode test,
. un module de contrôle CNT destiné à réaliser une inhibition de l'entrée d'horloge du coeur CORE en mode test, agencé de manière à ce que ladite inhibition soit levée pendant une durée prédéterminée après qu'un signal de détection Shdv aura été activé.

Dans ce circuit intégré, les cellules mémoire DIi (pour i=1 à N) et DOj (pour j=1 à P) sont réalisées sous la forme de bascules D et forment respectivement un registre de contrôle CR et un registre d'observation OR. Ces registres sont reliés à un port série TPORT, qui est destiné à échanger des informations relatives à des adresses Add, à des données Dat et à des opérations Ope avec une machine de test DBUG, le plus souvent externe au circuit intégré IC, machine qui pilote l'ensemble des opérations de test décrites dans cet exposé.

Selon le mode de réalisation choisi, le signal de détection Shdv sera activé par la machine DBUG lorsqu'elle aura ordonné soit une sélection d'une adresse virtuelle, soit une opération, par exemple un décalage, relative à une telle adresse.

Lorsque le circuit intégré est en mode de fonctionnement normal, un signal de contrôle T/R des multiplexeurs MIi (pour i=1 à N) et MOj (pour j=1 à P) présente un état inactif, par exemple un niveau logique 0, de sorte que les entrées INi (pour i=1 à N) et les sorties OUTj (pour j=1 à P) du coeur CORE sont respectivement connectées à des entrées Ii (pour i=1 à N) et à des sorties Oj (pour j=1 à P) du circuit intégré IC.

Lorsque le circuit intégré est en mode test, le signal de contrôle T/R présente un état actif, par exemple un niveau logique 1, et les entrées INi (pour i=1 à N) et les sorties OUTj (pour j=1 à P) du coeur CORE sont respectivement connectées aux sorties des cellules mémoire DIi (pour i=1 à N) et aux entrées des cellules mémoire DOj (pour j=1 à P).

L'entrée d'horloge du coeur CORE étant à priori inhibée en mode test, le coeur CORE est au repos.

Le test d'une séquence opératoire donnée se déroule généralement en trois temps :

Dans une première phase, dite de chargement, la machine DBUG écrit dans le registre de contrôle CR des informations représentant des stimuli à appliquer au coeur CORE pour en émuler une séquence opératoire déterminée. Un tel chargement est cadencé au moyen du deuxième signal d'horloge Clk2, en ordonnant autant de décalages du contenu du registre d'observation que nécessaire au moyen d'un signal de décalage S simultanément appliqué à toutes les cellules mémoire formant le registre d'observation OR.

Dans une deuxième phase, dite d'émulation, le coeur CORE est remis en fonctionnement au moyen d'un signal d'horloge afin qu'il soit possible d'observer ses réponses aux stimuli contenus dans le registre de contrôle CR. L'inhibition de l'entrée d'horloge du coeur est alors levée par le module de contrôle CNT et le coeur CORE reçoit le nombre d'impulsions d'horloge requis pour mener à terme la séquence opératoire choisie. Dans l'exemple de réalisation décrit ici, une impulsion d'horloge est transmise au coeur à chaque fois qu'une opération de décalage est commandée par la machine DBUG en relation avec une adresse virtuelle ne correspondant à aucune cellule mémoire. Un tel événement est identifié par un état actif du signal de détection Shdv transmis par le port série TPORT au module de contrôle CNT.

A l'issue de cette phase d'émulation, le registre d'observation OR mémorise les signaux présents aux sorties OUTj (pour j=1 à P) du coeur CORE.

Dans une troisième phase, dite de validation, la valeur du contenu du registre d'observation OR est comparée par la machine DBUG avec une valeur numérique de référence, représentative de la réponse que le coeur CORE devait apporter aux stimuli qu'il a reçus. En cas d'identité entre ces valeurs, il sera conclu que le coeur CORE a correctement exécuté la séquence opératoire choisie.

Dans certains cas, les rôles des registres de contrôle et d'observation CR et OR seront inversés. En effet, si l'on souhaite tester un périphérique non-représenté sur la figure, par exemple un bloc de mémoire RAM, c'est le registre d'observation OR qui contiendra des stimuli simulant des commandes provenant du coeur CORE, en réponse auxquels le périphérique délivrera des signaux en direction du coeur CORE, signaux qui seront alors mémorisés par le registre de contrôle CR en vue de leur validation par la machine DBUG.

Ceci explique que les entrées D des cellules mémoires DIi (pour i=1 à N) et les sorties Q des cellules mémoire DOj (pour j=1 à P) soient respectivement connectées aux entrées Ii (pour i=1 à N) et aux sorties Oj (pour j=1 à P) du circuit intégré IC, bien que les opérations d'écriture/lecture des registres de contrôle ou d'observation CR et OR se fassent à priori en mode série via le port série TPORT.

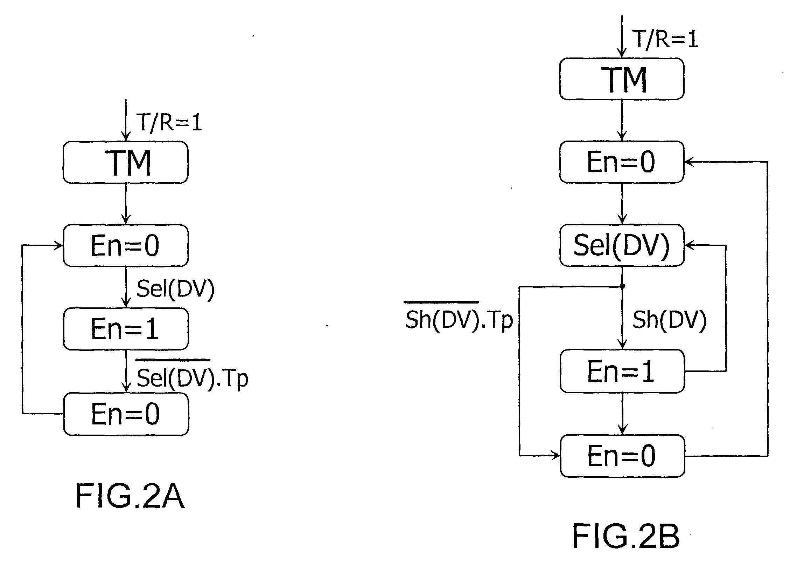

La figure 2A représente le déroulement d'une séquence d'inhibition/levée d'inhibition implémentée par le module de contrôle selon l'invention. Dans cette séquence, le circuit intégré est configuré en mode test au cours d'une première étape TM au moyen du signal T/R qui prend alors un état actif, ici le niveau logique 1. L'entrée d'horloge du coeur est immédiatement inhibée par la mise à un état inactif, ici le niveau logique 0, d'un signal d'autorisation En. Si une adresse virtuelle DV ne correspondant à aucune des cellules mémoire est sélectionnée par la machine DBUG via le port série, le signal d'autorisation En est placé à l'état actif : En=1. Il reste à l'état inactif sinon. Si, au bout d'un temps Tp, que l'on choisira avantageusement égal à une période du signal d'horloge acheminé vers l'entrée d'horloge du coeur pendant la phase d'émulation, de sorte qu'une seule impulsion d'horloge ne parvienne au coeur pour chaque sélection d'une adresse virtuelle DV, aucune nouvelle sélection Sel(DV) d'adresse virtuelle DV ne s'est produite, le signal d'autorisation sera à nouveau placé à l'état inactif : En=0. Il restera à l'état actif, soit En=1, dans le cas contraire, autorisant la transmission d'une autre impulsion d'horloge au coeur.

Ainsi, chaque sélection Sel(DV) d'une adresse virtuelle DV provoque la transmission d'une impulsion d'horloge au coeur.

La figure 2B représente le déroulement d'une séquence d'inhibition/levée d'inhibition implémentée par le module de contrôle selon une variante de l'invention. Dans cette séquence, le circuit intégré est configuré en mode test au cours d'une première étape TM au moyen du signal T/R qui prend alors un état actif, ici le niveau logique 1. L'entrée d'horloge du coeur est immédiatement inhibée par la mise à un état inactif, ici le niveau logique 0, d'un signal d'autorisation En. Si une adresse virtuelle DV ne correspondant à aucune des cellules mémoire est sélectionnée par la machine DBUG via le port série, la séquence se trouve dans une étape d'attente Sel(DV). Si, pendant cette étape d'attente, une opération de décalage Sh(DV) relative à l'adresse virtuelle DV est ordonné par la machine DBUG, le signal d'autorisation En est placé à l'état actif : En=1. Il reste à l'état inactif sinon. Si, au bout d'un temps Tp, que l'on choisira avantageusement égal à une période du signal d'horloge acheminé vers l'entrée d'horloge du coeur pendant la phase d'émulation, de sorte qu'une seule impulsion d'horloge ne parvienne au coeur pour chaque opération de décalage Sh(DV) relative à une adresse virtuelle DV, aucun nouveau décalage Sh(DV) n'est ordonné, le signal d'autorisation En sera à nouveau placé à l'état inactif : En=0. Il restera à l'état actif, soit En=1, dans le cas contraire, autorisant la transmission d'une autre impulsion d'horloge au coeur.

Ainsi, chaque opération de décalage Sh(DV) relative à une adresse virtuelle DV provoque la transmission d'une impulsion d'horloge au coeur.

Cette variante de l'invention exploite pleinement le format des séquences conformes au standard JTAG (pour Joint Test Action Group), selon lequel la sélection d'une adresse doit être suivie d'une ou plusieurs opérations de décalage relatives à cette adresse.

Grâce à l'invention, une machine DBUG conforme au standard JTAG pourra donc aisément piloter par voie logicielle la fourniture d'impulsions au coeur pendant la phase d'émulation sans qu'il soit nécessaire de modifier ladite machine à cet effet.

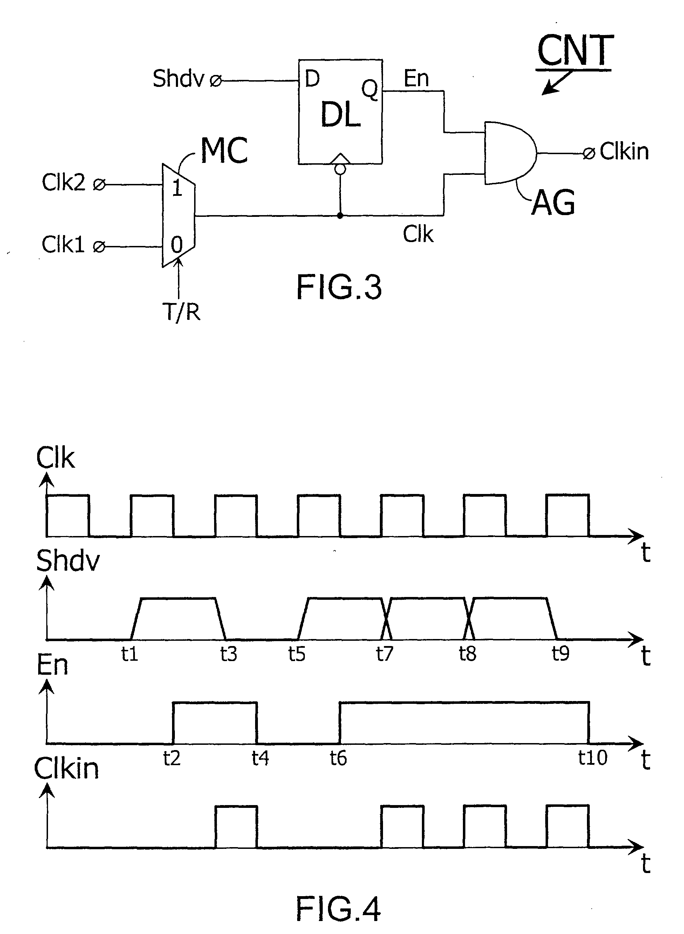

La figure 3 représente schématiquement un mode de réalisation possible du module de contrôle CNT. Dans cet exemple, le module de contrôle CNT inclut un porte ET AG, dont une sortie sera connectée à l'entrée d'horloge du coeur en vue de lui fournir un signal d'horloge Clkin, porte ET AG dont une entrée recevra un signal d'horloge Clk et dont une autre entrée recevra le signal d'autorisation En.

Un état inactif dudit signal En, c'est-à-dire dans cet exemple un niveau logique 0, commandera donc l'inhibition de l'entrée d'horloge du coeur, et un état actif du signal d'autorisation En, c'est-à-dire dans cet exemple un niveau logique 1, commandera une levée d'inhibition de l'entrée d'horloge du coeur.

Le module de contrôle CNT inclut en outre une cellule mémoire DL, réalisée ici au moyen d'une bascule D, dont une entrée de données D recevra le signal de détection Shdv, dont une sortie de données Q délivrera le signal d'autorisation En, et dont une entrée d'horloge recevra l'inverse du signal d'horloge Clk.

Le module de contrôle CNT inclut en outre un multiplexeur MC permettant de sélectionner, au moyen du signal de contrôle T/R dans cet exemple, celui des premier et deuxième signaux d'horloge Clk1 et Clk2 qui doit constituer le signal d'horloge Clk dont des fronts actifs seront transmis au coeur. Dans le cas présent, le coeur recevra le premier signal d'horloge Clk1 lorsque le signal de contrôle T/R sera inactif, c'est-à-dire au niveau logique 0, en mode de fonctionnement normal, et le deuxième signal d'horloge Clk2 lorsque le signal de contrôle T/R sera actif, c'est-à-dire au niveau logique 1, en mode test, à la condition que le signal d'autorisation En soit également actif.

La figure 4 représente l'évolution de signaux présents dans le module de contrôle décrit ci-dessus. Dans un premier temps, correspondant par exemple à une phase de chargement, le signal d'autorisation En est inactif et l'entrée d'horloge du coeur est inhibée. A un instant t1, le signal de détection Shdv est activé, et reste actif jusqu'à un instant t2. Cet état actif, représentatif d'une sélection d'une adresse virtuelle ou d'une opération relative à une telle adresse, selon le mode de mise en oeuvre de l'invention choisi, est mémorisé par la bascule D DL à un instant t2 correspondant au front descendant du signal d'horloge Clk qui suit l'instant t1. Le signal d'autorisation En est alors activé et provoque une levée de l'inhibition de l'entrée d'horloge du coeur. Une désactivation du signal de détection Shdv se produisant à un instant suivant t3 n'a pas d'influence sur le signal d'autorisation En. Le signal d'autorisation En restera actif au moins jusqu'à un instant t4 correspondant au front descendant suivant du signal d'horloge Clk, c'est-à-dire pendant une durée Tp égale à une période dudit signal Clk. Au cours de cette période, le signal d'horloge Clk aura présenté un front actif, en l'occurrence à l'instant t3, qui aura été transmis au coeur par le signal Clkin. A l'instant t4, le signal de détection Shdv n'ayant pas été réactivé, le signal d'autorisation En est désactivé et l'entrée d'horloge du coeur est à nouveau inhibée. Il ressort clairement de cette séquence qu'à une sélection d'une adresse virtuelle ou d'une opération relative à une telle adresse, selon le mode de mise en oeuvre de l'invention choisi, correspond la transmission d'une impulsion d'horloge au coeur.

A un instant t5, le signal de détection Shdv est réactivé, provoquant une activation du signal d'autorisation En à un instant t6 correspondant au front descendant du signal d'horloge Clk qui suit l'instant t5. Le signal de détection Shdv est successivement réactivé à des instants consécutifs t7 et t8, et désactivé à un instant t9. Ce cas de figure illustre trois sélections successives d'adresse virtuelle, ou trois opérations successives relatives à une adresse virtuelle, selon le mode de mise en oeuvre de l'invention choisi. Le signal d'autorisation En est ainsi activé pendant trois périodes successives du signal d'horloge Clk, permettant, du fait de la levée de l'inhibition qu'il commande, de transmettre au coeur trois impulsions d'horloge par le signal Clkin. A un instant t10, le signal de détection Shdv n'ayant pas été réactivé, le signal d'autorisation En est désactivé et l'entrée d'horloge du coeur est à nouveau inhibée. Il ressort clairement de cette séquence qu'à N sélections successives d'une adresse virtuelle ou N opérations successives relatives à une telle adresse, selon le mode de mise en oeuvre de l'invention choisi, correspond la transmission de N impulsions d'horloge au coeur.

L'invention permet ainsi d'acheminer des impulsions d'horloge en mode test de manière simple et flexible, sans qu'aucune programmation préalable du nombre d'impulsions propre à la séquence opératoire testée ne soit nécessaire.

## Revendications

1. Procédé pour tester un circuit intégré incluant un coeur et une pluralité de cellules mémoire présentant des sorties et des entrées alternativement connectées à des entrées et à des sorties du coeur, le coeur étant muni d'une entrée d'horloge destinée à recevoir un premier signal d'horloge en mode de fonctionnement normal, chaque cellule mémoire étant identifiée par une adresse et munie d'une entrée d'horloge destinée à recevoir un deuxième signal d'horloge en mode test, l'entrée d'horloge du coeur étant soumise à une inhibition conditionnelle en mode test, procédé incluant les étapes suivantes :
. configuration du circuit en mode test,
. sélection d'une adresse dite virtuelle ne correspondant à aucune cellule mémoire,
. levée de l'inhibition de l'entrée d'horloge du coeur pendant une durée prédéterminée consécutive à ladite sélection.

2. Procédé conforme à la revendication 1, selon lequel l'entrée d'horloge du coeur reçoit le deuxième signal d'horloge lorsque l'inhibition de ladite entrée d'horloge est levée pendant le mode test.

3. Procédé conforme à la revendication 1, selon lequel la levée de l'inhibition de l'entrée d'horloge du coeur est en outre assujettie à l'exécution d'une opération relative à l'adresse virtuelle.

4. Procédé conforme à la revendication 1, selon lequel la levée de l'inhibition de l'entrée d'horloge du coeur est en outre assujettie à l'exécution d'une opération spécifique prédéterminée relative à l'adresse virtuelle.

5. Procédé conforme à la revendication 4, selon lequel l'opération spécifique prédéterminée est une opération de décalage.

6. Circuit intégré incluant :
. un coeur muni d'une entrée d'horloge destinée à recevoir un premier signal d'horloge en mode de fonctionnement normal,
. une pluralité de cellules mémoire présentant des sorties et des entrées alternativement connectées à des entrées et à des sorties du coeur, chaque cellule mémoire étant identifiée par une adresse et munie d'une entrée d'horloge destinée à recevoir un deuxième signal d'horloge en mode test,
. un module de contrôle destiné à réaliser une inhibition de l'entrée d'horloge du coeur en mode test, agencé de manière à ce que ladite inhibition soit levée pendant une durée prédéterminée après qu'une adresse virtuelle ne correspondant à aucune cellule mémoire ait été sélectionnée.

7. Circuit intégré conforme à la revendication 6, dans lequel le module de contrôle est configuré pour acheminer le deuxième signal d'horloge vers l'entrée d'horloge du coeur lorsque l'inhibition de ladite entrée est levée pendant le mode test.

8. Circuit intégré conforme à la revendication 6, dans lequel la levée de l'inhibition de l'entrée d'horloge du coeur pendant le mode test est en outre assujettie à l'exécution d'une opération relative à l'adresse virtuelle.
